# EUROPÄISCHE PATENTSCHRIFT

(11) **EP 1 329 694 B1**
(45) Veröffentlichungstag und Bekanntmachung des Hinweises auf die Patenterteilung: **21.04.2010**
(21) Anmeldenummer: 03090011.2
(22) Anmeldetag: 11.01.2003
(51) Int. Cl.: G01D 5/12, G01D 5/252, G01D 5/246, H01H 19/00, H03M 1/28, G01D 5/25

(54) **Stellelement zur Bedienung elektronischer Geräte**
Actuator for electronic devices
Dispositif de commande pour appareils électroniques

(30) Priorität: 16.01.2002 DE 10201608
(43) Veröffentlichungstag der Anmeldung: 23.07.2003
(73) Patentinhaber: Völckers, Oliver, 54294 Trier (DE)
(72) Erfinder: Völckers, Oliver, 54294 Trier (DE)
(74) Vertreter: Burghardt, Dieter

(56) Entgegenhaltungen:
- DE-A1- 3 417 905
- US-A- 5 695 048
- US-A- 5 815 094
- PATENT ABSTRACTS OF JAPAN Bd. 006, Nr. 129 (P-128), 15. Juli 1982 (1982-07-15) & JP 57 053616 A (TOKAI RIKA CO LTD), 30. März 1982 (1982-03-30)

## Beschreibung

Stellelement zur Bedienung elektronischer Geräte, das als Regler und Mehrfachschalter konfigurierbar ist und Verfahren zur Bedienung dieses Stellelementes für elektronische Geräte.

Die Erfindung betrifft ein Stellelement zur Bedienung elektronischer Geräte, das als Dreh-Steller und Schiebe-Steller ausgebildet ist und ein Verfahren für ein benutzerkonfigurierbares Stell-Element zur Bedienung elektronischer Geräte.

Für elektronische Geräte, die von Menschen eingestellt werden müssen, sind Bedienelemente bekannt. Diese basieren auf einer bestimmten Technik, die nachfolgend benannt ist.

Die bekannten Potentiometer sind als Dreh- oder Schieberegler ausgebildet und liefern je nach Position des Griffs einen spezifischen elektrischen Widerstand.

Bekannte Wahlschalter mit Raststellungen schließen alternativ einen von mehreren Stromkreisen je nach Griffposition.

Bekannte Drehimpulsgeber (JogDial) setzen eine Drehbewegung des Griffs in eine schnelle Abfolge von Impulsen um, die von einer Dekodiereinheit zur Veränderung eines Parameters interpretiert werden kann. JP-A-357 053 616 offenbart einen gattungsgemäßen Drehimpulsgeber.

Kodierscheiben enthalten mehrere Schalter, die je nach Stellung des Griffs in unterschiedlichen Kombinationen aktiviert werden.

Dabei sind Potentiometer und Wahlschalter üblicherweise mit einem Anschlag ausgestattet, d.h. sie erlauben maximal eine volle Drehung. Drehimpulsgeber und Kodierscheiben erlauben dagegen in der Regel eine unbegrenzte Zahl von Drehungen. Kodierscheiben benötigen im Vergleich zu Drehimpulsgebern wesentlich mehr Schalter für eine präzise Umsetzung der Griffbewegung und sind wegen dieses höheren Aufwandes kaum verbreitet.

Potentiometer erfordern eine spezielle Elektronik (Analog-Digital-Wandler), damit die bereitgestellten Einstellwerte von einem Mikroprozessoren ausgewertet werden können. Außer-dem sind Potentiometer durch die mechanische Reibung anfällig für Verschleiß und Verschmutzung und ihr elektrischer Wider-stand kann von der Raumtemperatur beeinflußt werden.

Auch die bekannten Wahlschalter mit permanent geschlossenen Kontakten haben ungünstige Eigenschaften. So müssen sie mechanisch mit großen Reserven dimensioniert sein, weil der Kontakt auch unter den verschiedensten Bedingungen geschlossen bleiben soll. In einem Autoradio beispielsweise soll ein Wahlschalter nicht nur bei erheblichen Erschütterungen, sondern auch bei Temperaturschwankungen zuverlässig funktionieren.

Die früher allgemein üblichen Potentiometer und elektromechanischen Schalter werden daher zunehmend von digitalen Tastern und Drehimpulsgebern verdrängt, zumal diese einfacher mit digitaler Elektronik kombiniert werden können. Außerdem sind die Herstellungskosten der digitalen Elemente niedriger, der Platzbedarf ist geringer und die Zuverlässigkeit höher.

Doch den technischen Vorteilen der Taster und Drehimpulsgeber stehen Nachteile bei der Bedienung gegenüber. Weder Taster noch Impulsgeber können durch ihre mechanische Stellung unterschiedliche Einstellungen kennzeichnen.

Bei einem mit einem Potentiometer realisierten Lautstärkeregler z.B. ist die Einstellung durch die zugehörige Skala sofort ersichtlich, und selbst Blinde können die Position ertasten. Dagegen liefert ein mit digitalen Drehimpulsen realisierter Lautstärkeregler keine solche Rückmeldung, weil der Griff ohne Anschlag beliebig drehbar ist und die absolute Position keine Bedeutung hat.

Ebenso können Taster einen gewählten Zustand nicht ohne ein elektronisches Display sichtbar machen, während bei Mehrfachwahlschaltern der Zustand auch hier an der Position des Griffs erkennbar ist.

Ziel der Erfindung ist es, diese Defizite der mit modernen digitalen Stellelementen erheblich erschwerten Bedienung für den Einsatz an leistungsfähigen elektronischen Geräten zu beseitigen und damit die paradoxe Situation, daß grundlegende Funktionen, wie die Lautstärke-Einstellung bei hochentwickelten modernen Geräten umständlicher zu handhaben sind als bei uralten Geräten mit Analogtechnik, zu überwinden, wobei ein solches bedienbares Stellelement zur Verwendung mit digitalen elektronischen Geräten geeignet sein und als Standardbauteil konzipiert und für unterschiedliche Anwendungen konfigurierbar sein muß.

Der Erfindung liegt die Aufgabe zugrunde, ein mechanisch bewegliches eine Dreh-Bewegung oder eine Schiebe-Bewegung auswertendes Stellelement zu entwickeln, das eine für digitale Elektronik geeignete Information über seine Position liefert und sowohl als stufenlos arbeitender Regler als auch als ein zur Umschaltung einer konfigurierbaren Stufenzahl geeigneter Schalter einsetzbar ist, d.h. das Stellglied sollte Impulse generieren, die von einer digitalen Elektronik ohne Analog/Digital-Wandlung interpretiert werden können, keine Temperaturabhängigkeit oder Ungenauigkeit aufgrund von mechanischem Verschleiß aufweisen und aus ergonomischen Gründen mechanisch beweglich sein, wobei die Stellungen des Elements gegenüber dem Gerätegehäuse unterscheidbar sind.

Die Aufgabe wird durch die im kennzeichnenden Teil genannten Merkmale der unabhängigen Ansprüche gelöst.

Erfindungsgemäß werden zwei Varianten vorgeschlagen, einmal ein Dreh-Stellelement und ein Schiebe-Stellelement, das auf dem gleichen Prinzip beruhen. Die Bedienung ist angelehnt an Dreh- bzw. Schiebe-Potentiometer, wobei ein kodiertes Leiterbahnmuster bei Bewegung des Stellelements elektrische Impulse erzeugt, die einer Dekodiereinheit Informationen über die Position des Stellelements liefern.

Das Stellelement läßt sich sowohl zur annähernd stufenlosen Einstellung als auch als Mehrfachwahlschalter nutzen, wobei das mechanische Verhalten des Stellelements durch einen auswechselbare Programmwähler bzw. -schiene beliebig definiert werden kann.

Das erfindungsgemäße Stellelement erlaubt eine besonders einfache Bedienung durch an die jeweilige Aufgabe angepaßte, fühlbare Einstellmöglichkeiten. Das Stellelement generiert digitale Impulse, die zur Verarbeitung mit elektronischen Schaltungen geeignet sind, ohne selbst elektronische Bauteile zu benötigen.

Die Erfindung soll an einem Ausführungsbeispiel näher erläutert werden. In der zugehörigen Zeichnung zeigen:
- Fig. 1: Blockschaltbild der Komponenten des erfindungsgemäß ausgebildeten Stellelement
- Fig. 2: Beispiel eines Schaltstreifens zur Generierung der Impulse
- Fig. 3: Kontaktträger eines erfindungsgemäßen Stellelements
- Fig. 4: Beispiel einer Impulsfolge durch eine Bewegung des Stellelements
- Fig. 5: Beispiel einer Impulsfolge an einer anderen Position des Stellelements
- Fig. 6: Impulsfolge bei ungleichmäßiger Bewegung
- Fig. 7: Erfindungsgemäßes Stellelement im Schnitt
- Fig. 8: Erfindungsgemäßes Stellelement, Ansicht von hinten
- Fig. 9: Programmwähler für ein als anschlaglosen Vierfach-Wahlschalter erfindungsgemäß ausgebildetes Stelleelement in Ansicht
- Fig. 10: Programmwähler nach Fig. 9 in Seitenansicht
- Fig. 11: Programmwähler für ein erfindungsgemäß als Regler ausgebildetes Stellelement mit zwei Schaltstufen und einem federnden Anschlag
- Fig. 12: Bedienung eines erfindungsgemäß als anschlaglosen Vierfach-Wahlschalter ausgebildeten Stellelementes
- Fig. 13: Bedienung eines erfindungsgemäß als Regler mit zwei Schaltstufen ausgebildeten Stellelementes
- Fig. 14: Ein als Schieberegler ausgebildeter Stellelement mit Rast-Position in Mittelstellung
- Fig. 15: Programmwähler eines als Schiebereglers ausgebildetes Stellelement mit Rast-Position in Mittelstellung

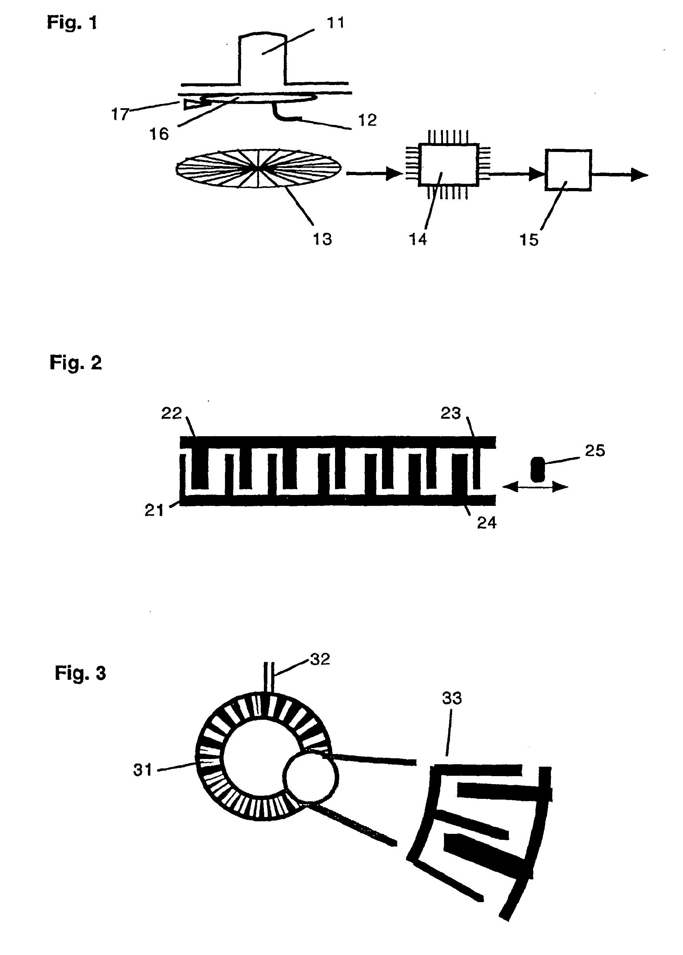

In Fig. 1 sind die Komponenten des erfindungsgemäßen Stellelements zusammen mit der zugehörigen elektronischen Dekodiereinheit 14 abgebildet. Am mechanisch beweglichen Griffs 11 des Stellelements befindet sich eine Kontaktfeder 12, die auf einem flächenförmigen Kontaktträger 13 im Falle eines Drehelements (bzw. einem entsprechendem Schaltstreifen im Falle eines schiebbaren Stellelements) bei Bewegung wechselnde Kontakte schließt.

Damit generiert die Kontaktfeder 12 entsprechend der Kontaktfolge der Balken digitale Impulse auf zwei Kanälen, deren relative Breite von einer Dekodiereinheit 14 untersucht wird. Aus diesem Verhältnis berechnet die Dekodiereinheit 14 die Position des Stellelements und überträgt sie in einen nichtflüchtigen Speicher 15.

Als Speichergröße genügt 1 Byte zur Unterscheidung von 256 Positionen des Stellelements, 2 Byte wären mehr als ausreichend. Weitere Komponenten des Geräts können den Inhalt dieses Speichers 15 jederzeit auslesen und durch eine entsprechende Software so interpretieren, daß die Eigenschaften des Geräts der jeweiligen Stellelement-Position entsprechen.

Die mechanischen Eigenschaften des Stellelements im Sinne von Raststufen und der Position eines Anschlags (fester Endstellungen) werden durch einen auswechselbaren Programmwähler 16 bzw. -streifen definiert. Dieser Programmwähler bzw. -streifen bewegt sich mit dem Stellelement und kann sich vor oder hinter dem Kontaktträger 13 befinden. Eine fest am Gehäuse angebrachte Programmfeder 17 tastet dabei die Kante des Programmwählers bzw. des -streifens ab. Die unterschiedliche Ausformung dieser Kante führt zu entsprechender Reibung der Programmfeder und erzeugt so Raststufen an den gewünschten Positionen.

Ein Beispiel für einen möglichen Schaltstreifen ist in Fig. 2 zu sehen. Hier handelt es sich um den Schaltstreifen eines Schiebestellers, das Prinzip von Schaltstreifen (Variante Schiebesteller) und Schaltscheiben (Variante Drehsteller) ist jedoch das Gleiche; die Balken sind in dem einen Fall gerade und in dem anderen kreisförmig angeordnet.

Der Schaltstreifen besteht aus zwei elektrisch leitfähigen Bahnen 21; 22, die zwei Kanälen von Signalen entsprechen. Ähnlich einer Barcode-Markierung von Artikeln im Supermarkt sind diese Bahnen mit Balken unterschiedlicher Breite versehen. In diesem Beispiel wechseln die Balken beider Kanäle immer einander ab, wobei am linken Ende der Skala die Balken von Kanal 1 schmal 21 und von Kanal 2 breit 22 ausgeprägt sind. Über die gesamte Länge des Streifens hinweg folgen immer wieder Balken beider Kanäle aufeinander, wobei die Breite der Balken von Kanal 1 zunimmt und die der Balken von Kanal2 abnimmt, bis sich am rechten Ende das Verhältnis vom Anfang umgekehrt hat 23; 24.

Wenn nun eine Kontaktfeder 12 in Fig. 1, 25 in Fig. 2 hier horizontal über den Schaltstreifen bewegt wird, bringt dies an den beiden Kanälen abwechselnd eine elektrische Spannung in der Form von digitalen High/Low-Pegeln an. Diese Impulse sind spezifisch für eine Bewegung an der jeweiligen Position des Stellelements. Bei einem Stillstand des Stellelements ist der Zustand undefiniert, d.h. zufällig.

Fig. 3 zeigt ein Beispiel für eine runde Schaltscheibe 31 eines Drehstellers. Hier bilden die innen und außen liegenden Bahnen einen Vollkreis mit Ausnahme einer sehr kleinen Unterbrechung des äußeren Rings dort, wo die Leiterbahn des inneren Rings herausgeführt wird 32. Ein Ausschnitt der Schaltscheibe ist zur Verdeutlichung vergrößert dargestellt 33. Anfang- und Ende-Position des Balken-Musters schließen bei der Schaltscheibe direkt aneinander an und liegen dort, wo die Kontakte herausgeführt werden (im Beispiel oben).

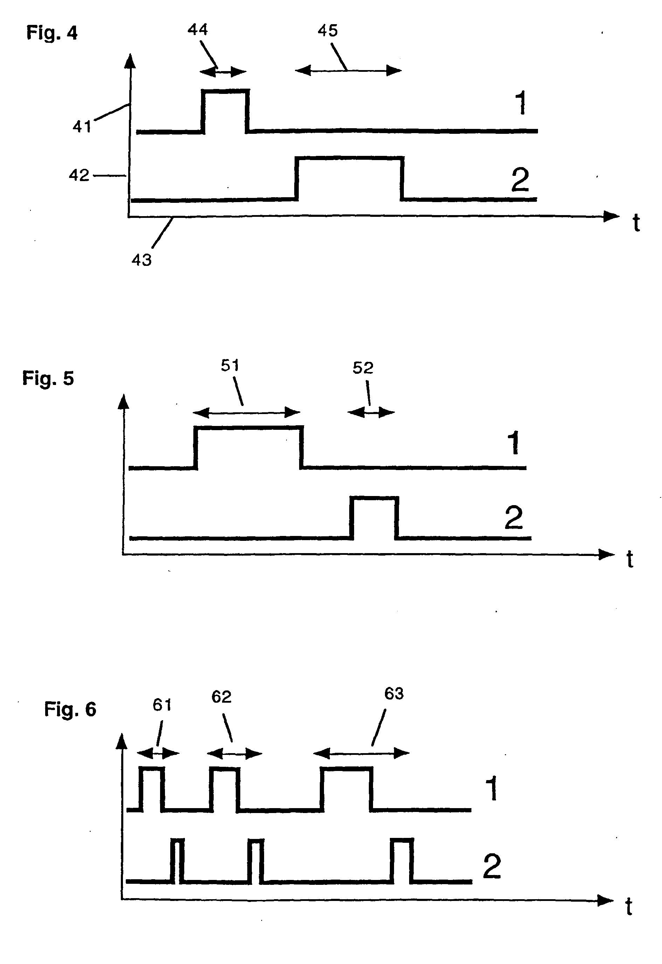

Bei einer Bewegung des Stellelements liegen an den beiden Kanälen Signale an, die in Fig. 4 beispielhaft skizziert sind. Sowohl der Kanal 1; 41 als auch Kanal 2; 42 weisen abwechselnd High- und Low-Pegel auf, die hier über einen kurzen Zeitraum (43) betrachtet werden. Wie breit die Impulse erscheinen, hängt ab von der Geschwindigkeit, mit der das Stellelement bewegt wird. Typisch sind Frequenzen im Bereich von 0,5 bis 50 Hertz, wobei der Pegel rund 5-40% der Zeit auf High liegen kann.

Die absolute Dauer der Impulse ist unerheblich, da sie wie erwähnt nur die Bewegungsgeschwindigkeit ausdrückt. Vielmehr analysiert die Dekodiereinheit 14 in Fig. 1 nur das Verhältnis der Dauer zwei auf einander folgender Impulse.

Da die Balken des Schaltstreifens in dem beschriebenen speziellen Muster angeordnet sind, lässt sich die Position des Stellelements aus der relativen Breite der Impulse auf Kanal 1; 44 und Kanal 2; 45 errechnen. Dazu wird von der Breite1 44 die Mindestbreite der Endposition subtrahiert und das Ergebnis in Verhältnis zur Gesamtbreite gesetzt, wobei sich die Gesamtbreite aus der Summe von Breite 1; 44 und Breite 2; 45 minus der Mindestbreite ergibt.

Die Mindestbreite ist ein fester Anteil der Summe von Breite 1; 44 und Breite 2; 45 und hängt von dem jeweiligen Balkenmuster ab. Eine Mindestbreite von 10% der Maximalbreite ist sinnvoll und bedeutet, dass an den beiden Enden der breite Streifen ungefähr zehn Mal so breit ist wie der schmale Streifen.

So ergäbe sich bei Fig. 4 eine Position des Stellelements an der einen Seite, während die Impulse von Fig. 5 eine Position des Stellelements an der anderen Seite signalisieren. Die Genauigkeit der Positionsbestimmung hängt vor allem von der mechanischen Präzision der Komponenten ab. Die Genauigkeit der Impulsdauer-Messung ist bei den heute üblichen Schaltkreisen ausreichend, um mehr als hundert Zustände unterscheiden zu können. Bei der Nutzung des Stellelements für eine annähernd stufenlose Regelung sind rund 30 bis 50 Positionen ausreichend, da eine solch feine Abstufung wie bei den Einzelbildern eines Films als gleitende Bewegung wahrgenommen wird.

Bei einer ungleichmäßigen Bewegung entspr. Fig. 6 entsteht eine leichte Ungenauigkeit dadurch, dass die Bewegung bei der Abgabe der Impulse von Kanal 1 und 2 unterschiedlich schnell sein kann 61, 62, 63. Dieser Faktor kann, wenn nötig, durch eine Software ausgeglichen werden, die die Veränderung der Bewegungsgeschwindigkeit über mehrere Impulse interpoliert.

Die Abtastelektronik (Nr. 14 in Fig. 1) führt folgende Schritte aus um die Impulsfolgen auszuwerten:
Sie registriert jede Änderung des Pegels der beiden Kanäle und speichert den exakten Zeitpunkt der jeweils letzen Pegel-

Änderungen. Als Zeitpunkt eignet sich der in Mikrocontrollern üblicherweise vorhandene Timer-Funktion, die eine System-Uhrzeit ausgehend von einem willkürlichen Startpunkt z.B. in Millisekunden misst. Ein solcher Timer lässt sich durch Differenzbildung zweier Zeitpunkte problemlos als Stoppuhr nutzen. Für die erfindungsgemäße Anwendung sind sechs Register nötig:
1. Kanal 1: hightime
2. Kanal 1: lowtime
3. Kanal 1: pend.-hightime
4. Kanal 2: hightime
5. Kanal 2: lowtime
6. Kanal 2: pend.-hightime

Bei einer steigenden Flanke (Pegel wechselt von Low auf High) wird der Timer-Zeitpunkt dieses Ereignisses im Register "pend.-hightime" des betroffenen Kanals festgehalten. Jetzt ist ein Impuls aktiv und der Pegel steht auf "High".

Bei einer fallenden Flanke (Pegel wechselt von High auf Low) wird der Timer-Zeitpunkt dieses Ereignisses im Register "lowtime" des betroffenen Kanals festgehalten. Außerdem wird der Inhalt des Registers "pend.-hightime" des entsprechenden Kanals in das Register "hightime" kopiert. Jetzt ist ein Impuls komplett verarbeitet und der Pegel steht auf "Low".

Die Differenz von lowtime- und hightime-Zeitpunkt ergibt die Impulslänge des letzten vollständigen Impulses in jedem Kanal. Aus dem Verhältnis dieser beiden Impulslängen lässt sich die Position des Stellelements berechnen wie zuvor beschrieben.

Die genannten Schritte beschreiben nur in groben Zügen eine mögliche Dekodiereinheit (14). Diese Basis ließe sich ohne weiteres erweitern. Z.B. könnte eine Plausibilitätsprüfung einzelne Messwert-Ausreißer herausfiltern. Damit können Ungenauigkeiten weggefiltert werden, die durch eine ungleichmäßige Bewegung des Griffes (11) mit Kontaktfeder (12) des Stellelements hervorgerufen werden könnten. Außerdem könnten die Zwischenräume zwischen den Impulsen beider Kanäle von den Zwischenräumen zwischen den Impulsen desselben Kanals unterschieden werden, um die Präzision zu erhöhen.

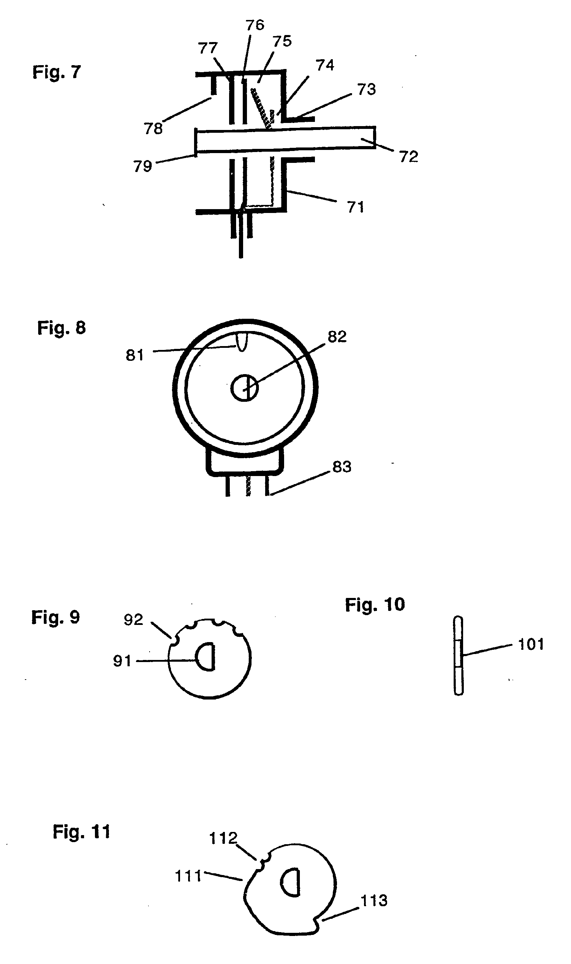

Die mechanische Konstruktion eines erfindungsgemäßen Stellelements ist in Fig. 7 im Querschnitt zu sehen. Ein elektrisch isoliertes Gehäuse 71 umfasst die Drehachse 72 an einer Durchführung 73, die wie bei bekannten Drehpotentiometern mit einem Außengewinde versehen sein kann, um das Element an einer Gerätefrontplatte zu befestigen. Über eine Zuleitung mit Kontaktring 74 wird die elektrische Verbindung zu der Kontaktfeder 75 (Nr. 12 in Fig. 1) hergestellt. Diese Kontaktfeder berührt die Schaltscheibe 76 (Nr. 13 in Fig. 1), die mechanisch von der Gehäuserückwand 77 gehalten wird.

Die Rückseite des Drehstellers enthält einen Hohlraum zur Aufnahme einer nachfolgend beschriebenen runden Programmwähler. Am oberen Rand dieses Hohlraums befindet sich eine biegsame Programmfeder 78, die die äußeren Konturen einer eingelegten Programmdiskette abfahren kann. Der Programmwähler wird durch einen Riegel 79 am rückwärtigen Ende der Achse 72 fixiert.

Fig. 8 zeigt dieses Stellelement von hinten. Die Programmfeder 81 (Nr. 78 in Fig. 7) zeigt in Richtung der drehbaren Achse 82. Dabei ist die Rückseite der Achse wie bei der Vorderseite von bekannten Mehrfachwahlschaltern an einem Ende abgeflacht, um eine feste Steckverbindung zu ermöglichen. Die elektrischen Kontakte der beiden Leiterbahnen (83 außen, Nr. 76 in Fig. 7) sowie der Kontaktfeder (83 Mitte, Nr. 74 in Fig. 7) sind wie bei bekannten Drehpotentiometern nach unten herausgeführt, um z.B. eine Lötmontage auf Platinen zu unterstützen.

Der Programmwähler (Fig. 9 von vorn, Fig. 10 seitlich, Fig. 11 von vorn) kann nun in den Hohlraum des Drehsteller-Gehäuses (Nr. 78 in Fig. 7) eingelegt werden, worauf sie an der elastischen Verriegelung (Nr. 79 in Fig. 7) automatisch einrastet. Das ist allerdings nur möglich, wenn sich die Aussparung des mittleren Lochs (91, 101 in Fig. 10) im richtigen Winkel zu der Abflachung des Achse (82 in Fig. 8) befindet.

Diese Aussparung gewährleistet, daß sich der Programmwähler bei jeder Drehung der Achse mitbewegt, wobei die Programmfeder den Rand ähnlich einer mechanischen Schallplatte abtastet.

Der Programmwähler kann am Rand mit unterschiedlichen Einkerbungen 92 versehen sein, die zur Programmfeder (Nr. 78 in Fig. 7) passen. Bei jeder Kerbe rastet der Drehsteller ein, so dass sich bei einer Drehbewegung der Eindruck eines mechanischen Wahlschalters ergibt. Das Beispiel von Fig. 9 entspricht einem 4-fach Wahlschalter ohne Anschlag, d.h. der Griff kann auch mehrfach gedreht werden und außerhalb der Raststufen beliebige Positionen einnehmen.

Je nach Form des Rands kann der Programmwähler ein sehr unterschiedliches Verhalten des Drehstellers erreichen. Dasselbe Element kann je nach Programmdiskette wahlweise wie ein Drehregler, Wahlschalter mit unterschiedlichen Stellungen oder als Kombination davon erscheinen.

Dabei muß natürlich eine passende Software gewährleisten, daß die entschlüsselten und gespeicherten (Nr. 15 von Fig. 1) Positionen auch zu einer passenden Reaktion des Geräts führen. Es genügt dazu eine Tabelle mit einer Gegenüber-stellung von Drehpositionen und erwünschten Software-Ein-stellungen. Der Aufbau dieser Tabelle hängt wesentlich von dem verwendeten Programmwähler ab. Allgemein besteht das Verfahren zur Interpretation der berechneten Positionen des Stellelements aus folgenden Schritten:
1. Position des Stellelements vom Speicher (Nr. 15 in Fig. 1) abfragen
2. Zugeordnete Aktion laut Tabelle abrufen
3. Aktion von 2. ausführen
4. Fortsetzen mit 1

Je nach Programmwähler entsprechen definierten Wertebereichen der Positionen bestimmte Aktionen. Z.B. könnten Vorschriften aus der Tabelle lauten "0 bis 30 Grad: Raststufe UKW-Senderwahl; 31 bis 60 Grad: Raststufe MW-Senderwahl; 61 bis 90 Grad: Raststufe LW-Senderwahl).

Im einzelnen sind durch die Höhe des Randes der Programmwähler an jedem spezifischen Winkel folgende Ver-haltensweisen festlegbar: Die Maximalhöhe blockiert die Programmfeder (81 in Fig. 8) und bedeutet einen festen Anschlag. Ein schräger Aufstieg zu der Maximalhöhe bedeutet einen federnden Anschlag, der sich wie ein Drehtaster anfühlt.

Eine Kerbe bedeutet eine Raststufe, wobei eine tiefere Kerbe eine härtere Rastung erzeugt, weil die Programmfeder dann fester in dieser Kerbe sitzt. Andererseits kann eine Vielzahl sehr kleiner Kerben das Gefühl einer Ratsche vermitteln. Eine Höhe unterhalb des Maximums kann die Programmfeder bremsen und die Drehbewegung absichtlich erschweren.

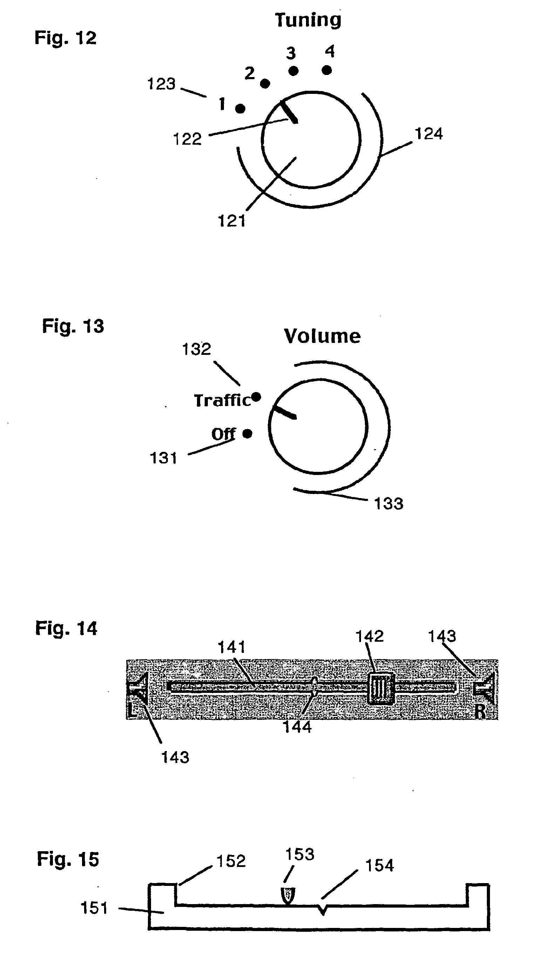

Wenn die Programmfeder an einer Stelle keinen Programmwähler berührt, kann sich der Drehsteller dort frei bewegen. Ist überhaupt keine Programmdiskette eingelegt, ist auch kein Anschlag vorhanden, so dass sich der Drehsteller verhält wie ein Drehimpulsgeber (JogDial). Die Benutzeroberfläche der Beispiele von Fig. 9 und 11 für Programmwähler ist übrigens in Fig. 12 und Fig 13 sichtbar.

Der Programmwähler von Fig. 11 enthält auf der linken Seite einen federnden Anschlag 111, dann kurz hinter einander zwei Raststellungen 112 und dann einen längeren Regelbereich bis zum Anschlag 113.

Fig. 12 zeigt eine Anwendung für der Programmwähler von Fig. 9 am Beispiel des Senderknopfs eines Autoradios. Moderne digitale Autoradios sind so überflutet mit Tasten, dass die simple Auswahl voreingestellter Sender oder die Frequenzeinstellung die Lektüre der Bedienungsanleitung erfordert. Dabei genügt für diese Aufgabe ein einziges erfindungsgemäßes Stellelement, der sich innerhalb von Sekunden sogar blind bedienen läßt.

Der Drehknopf 121 ist mit einer Positionsmarkierung 122 versehen, die sich beliebig auf eine von vier Raststellungen 123 oder einen frei einstellbaren Bereich 124 stellen lässt. Die vier Raststellungen können bei einem Autoradio vier voreingestellte Sender auswählen, während der Bereich 124 die Auswahl der Frequenz erlaubt. Dabei werden die Frequenzen weggelassen, an denen sich kein Sender befindet. Denkbar wäre für diese Anwendung auch, den Bereich 124 mit einer Vielzahl (z.B. 30) weicher Stufen auszustatten.

Fig. 13 zeigt eine Anwendung für den Programmwählere von Fig. 11 am Beispiel des Einschalters und Lautstärkereglers eines Autoradios. In der linken Raststellung 131 ist das Autoradio ausgeschaltet. Die nachfolgende Raststellung schaltet auf Verkehrsfunk-Bereitschaft, d.h. das Radio ist stumm und ist nur bei Verkehrsdurchsagen hörbar. Mit dem nachfolgenden Regelbereich ist die Lautstärke einstellbar bis zum Anschlag 133. Zusätzlich verfügt dieser Drehknopf auf Grund der Abschrägung des Programmwählers (Nr. 111 in Fig. 11) über einen federnden Anschlag. D.h., der Drehknopf kann über die Position "Off" hinaus bewegt werden, wirkt dann wie ein Taster und springt beim Loslassen zurück auf "Off". So ließen sich Spezialfunktionen für Fortgeschrittene realisieren, die dann in der Bedienungsanleitung erklärt werden.

Alle diese Mechanismen (Schaltscheiben, wechselbarer Programmwähler, Programmfeder zur Abtastung, federnder Anschlag) lassen sich gleichermaßen mit Drehstellern und Schiebestellern nutzen. Nur eine Endlosbewegung bleibt auf den Drehsteller beschränkt, wenn man mal von der theoretischen Möglichkeit eines kreisförmigen Schiebestellers absieht.

Fig. 14 zeigt ein Beispiel für einen erfindungsgemäßen Schiebesteller. Ein Schiebegriff 142 lässt sich entlang einer Schiene 141 bewegen, an der bestimmte Positionen (143, 144) hervorgehoben sind. Das Beispiel dient als Balance-Regler und rastet in der Mittelstellung 144 leicht ein.

In Fig. 15 ist der zugehörige Programmwähler in länglicher Ausführung bzw. Programmschiene 151 dargestellt. Auch er ist wechselbar wie der runde Programmwähler von Drehstellern und kann eine variable Form erhalten. An beiden Enden führt die steile Kante 152 zu einem festen Anschlag. Die Programmfeder 153 rastet in der Mittelstellung bei der Kerbe 154 leicht ein.

Die Erfindung reagiert auf Impulse, die bei Bewegungen des Griffes Stellelements generiert werden. Bei Stillstand kann die Position nur über den nichtflüchtigen Speicher (Nr. 15 in Fig. 1) abgefragt werden. Dies führt zu dem Problem, daß nach einem Stromausfall des Systems und bei der ersten Inbetriebnahme die Position des Griffes des Stellelements bis zur ersten Betätigung unbekannt ist. Schließlich ist es möglich, daß während des Stromausfalls der Griff 11 und damit die Kontaktfeder 12 bewegt wurde, ohne daß dies von der Dekodiereinheit (Nr. 14 in Fig. 1) erkannt wurde.

Zwei Lösungen dieses Problems werden vorgeschlagen. Zum einen kann der zufällige Wert, der an den Kanälen 1 und 2 anliegt, in einem zusätzlichen nichtflüchtigen Speicher gepuffert werden. Ist der Inhalt nach dem Stromausfall unverändert, kann das System darauf spekulieren, daß die Stellung gleich geblieben ist; anderenfalls fordert eine Software zur kurzen Betätigung des Stellelements auf. Diese Lösung ist sehr simpel und wird meistens funktionieren, aber beinhaltet ein gewisses Fehlerrisiko, das bei der Bedienung verwirren könnte.

Eine sichere, wenn auch aufwendigere Lösung besteht darin, die Dekodiereinheit (Nr. 14 in Fig. 1) und den Speicher (Nr. 15 in Fig. 1) ständig in Betrieb zu halten, auch wenn das Gerät ausgeschaltet ist. Bei modernen Geräten ist diese Lösung weniger aufwendig als es zunächst scheint, denn ohnehin enthalten die meisten elektronischen Geräte (Telefone, Kameras, Fernseher, Radios) heute eine batterie- oder akkugepufferte Uhr. Andere Geräte werden nicht mehr ausgeschaltet, sondern wechseln in einen Standby-Betrieb. Diese vorhandene Stromversorgung kann die Dekodiereinheit ununterbrochen betreiben.

Im Vergleich zu Potentiometern in Dreh- oder Schiebeausführung liefert die Erfindung digitale Impulse, die von modernen Schaltungen besser ausgewertet werden können als analoge Messwerte. Die erfindungsgemäßen Stellelemente sind keinen Schwankungen ausgesetzt, wie sie bei analogen Widerstandsmessungen durch Temperaturwechsel, Alterung der Komponenten oder Verschleiß entstehen können. Während die Auflösung (Anzahl Stufen) in Abhängigkeit von der Schaltscheibe bzw. dem Schaltstreifen eher geringer ist als bei Potentiometern, ist die absolute Genauigkeit (Übereinstimmung des Messwerts mit Realität) deutlich höher, da die digitale Kodierung eine sehr sichere Zuordnung der Position erlaubt. Die Auflösung ist je nach Erfordernissen höher oder geringer durch ein entsprechendes Balkenmuster wählbar.

Im Gegensatz zu Drehimpulsgebern ist die Erfindung jederzeit über die Position des Griffs des Stellelementes informiert, weil sie nicht bloß die Bewegungsrichtung erkennt. Über die kombinierte variable Impulsbreite der Erfindung wird eine Information vermittelt, die Drehimpulsgebern fehlt, obwohl auch sie zwei Kanäle benötigen.

Über den wechselbaren Programmwähler kann das erfindungsgemäße Bauelement wahlweise mit einem völlig unterschiedlichem Bedienverhalten ausgestattet werden. So kann ein Stellelement selbst nachträglich und im eingebauten Zustand noch umkonfiguriert werden.

Ein und dasselbe Stellelement kann wahlweise wie ein Wahlschalter mit einer beliebigen Anzahl von Stellungen, wie ein stufenloser Regler, als Drehtaster mit federndem Anschlag oder wie ein Drehimpulsgeber ohne Anschlag erscheinen. Auch Kombinationen von Reglern und Schaltern sind möglich, ohne daß dafür zusätzliche Kosten entstehen. Selbst die mechanischen Eigenschaften wie etwa die Festigkeit der Wahlschalter-Stufen können durch entsprechende Programmwähler variiert werden.

Bei der Herstellung und dem Service elektronischer Geräte kann durch die Erfindung ein einziges Standard-Bauelement für eine Vielzahl von Anwendungen eingesetzt werden. Bisher war eine Lagerhaltung etwa von Wahlschaltern mit einer unterschiedlichen Anzahl von Stellungen sehr aufwendig, dies entfällt.

Die Gehäuseform und die Anzahl der Kontakte (3) entspricht der von traditionellen Potentiometern und Drehimpulsgebern, was eine Umstellung vereinfacht. Die Ausführung ist sowohl als Drehsteller als auch als Schiebesteller möglich.

Für moderne elektronische Geräte steht jetzt ein Bauelement zur Verfügung, das die Position des Griffs von Dreh- und Schiebe-Steller berücksichtigt und zur Verarbeitung geeignete digitale Impulse liefert. Damit lassen sich Bedienkonzepte realisieren, die ohne verwirrende Betriebsarten-Anzeigen und Zustandswechsel auskommen. Die Zustände werden einfach durch die Position des Griffs der Stellelemente ausgedrückt.

### Bezugszeichen-Aufstellung

- 1: Kanal
- 2: Kanal

- 11: Griff
- 12: Kontaktfeder
- 13: Kontaktträger
- 14: Decodiereinheit
- 15: Speicher
- 16: Programmwähler
- 17: Programmfeder

- 20: Leiterbahn
- 21: Leiterbahn
- 23: Kammzahn
- 24: Kammzahn
- 25: Kontaktfeder

- 31: Kontaktträger
- 32: Leiterbahn
- 33: Ausschnitt

- 41: High-Pegel
- 42: Low-Pegel
- 43: Zeitraum
- 44: Impuls auf Kanal 1
- 45: Impuls auf Kanal 2

- 51: Impuls
- 52: Impuls

- 61: Impuls
- 62: Impuls
- 63: Impuls

- 71: Gehäuse
- 72: Drehachse
- 73: Durchführung
- 74: Kontaktring
- 75: Kontaktfeder
- 76: Schaltscheibe
- 77: Gehäuserückwand
- 78: Progrmmfeder
- 79: Riegel

- 81: Kontaktfeder
- 82: Achse mit Abflachung
- 83: Schnittstelle

- 91: Aufnahme
- 92: Einkerbung

- 101: Aufnahme
- 111: Anschlag
- 112: Raststellung
- 113: Anschlag

- 121: Drehknopf
- 122: Positionsmarkierung
- 123: Raststellung
- 124: einstellbarer Bereich

- 131: Raststellung
- 132: Raststellung
- 133: Anschlag

- 141: Schiene
- 142: Schiebegriff
- 143: Position
- 144: Mittelstellung

- 151: Programmschiene
- 152: Kante
- 153: Programmfeder
- 154: Kerbe

## Patentansprüche

1. Stellelement zur Bedienung elektronischer Geräte, umfassend einen Griff (11) des Stellelementes, der mechanisch beweglich in einem Gehäuse (71) gelagert ist,
eine auf einem als Scheibe oder Bahn ausgebildeten, vorgesehenen Kontaktträger (13) gleitend angeordneten Kontaktfeder (12), welche mit dem Griff verbunden ist,
und eine durch Bewegung des Griffes (11) und Kontaktschliessung der Kontaktfeder (12) auf zwei kodierten Leiterbahnenmustern abgegebenen Impulsen verarbeitende Dekodiereinheit (14),
**dadurch gekennzeichnet, dass**
der Kontaktträger (13) zwei mit je einem kodierten Leiterbahnmuster versehene Leiterbahnen aufweist, deren Musterabfolge für jede Position des Griffs (11) des Stellelementes spezifisch ist,
die Position des Griffs (11) des Stellelementes aus dem zeitlichen Verhältnis der Impulse von den beiden Leiterbahnmustern mit der Dekodiereinheit (14) berechenbar ist,
und ein nachgeordneter elektronischer Speicher (15), dessen Inhalt jederzeit die Position des Griffs (11) des Stellelementes ausdrückt, vorhanden ist

2. Stellelement nach Anspruch 1, ***dadurch gekennzeichnet,* daß** der durch die Kontaktfeder (12) beaufschlagte Kontaktträger (13) zwei getrennte Leiterbahnen (21; 22) aufweist, die je einen Kanal (1; 2) bilden und die mit der elektronischen Dekodiereinheit (14) über eine Schnittstelle verbunden sind.

3. Stellelement nach Anspruch 1 und 2, ***dadurch gekennzeichnet*, daß** die Leiterbahnen (21; 22) parallel zu einander in einer Ebene liegend angeordnet sind.

4. Stellelement nach Anspruch 1 bis 3, ***dadurch gekennzeichnet*, daß** die Leiterbahnen (21; 22) kammförmig ausgebildet sind und Kammzähne der einen Leiterbahn in Zwischeräume zwischen zwei Kammzähnen der anderen Leiterbahn liegend angeordnet sind.

5. Stellelement nach Anspruch 4, ***dadurch gekennzeichnet*, daß** die Kammzähne der Leiterbahnen (21; 22) eine unterschiedliche Breite aufweisen und die Breiten von einem zum anderen Ende einer Leiterbahn ansteigend ausgebildet sind.

6. Stellelement nach Anspruch 4 bis 5, ***dadurch gekennzeichnet*, daß** die parallel liegenden, kammförmig ausgebildeten Leiterbahnen mit einer gegenläufigen Breitenabfolge zueinander angeordnet sind, wobei jeweils ein schmaler Kammzahn der einen Leiterbahn in einen Zwischenraum zwischen zwei breiteren Kammzähnen der anderen Leiterbahn eingreifend angeordnet ist.

7. Stellelement nach Anspruch 3 bis 6, ***dadurch gekennzeichnet*, daß** die mit Kammzähnen versehenen parallel liegenden Leiterbahnen in der Zuordnung zueinander ein kodiertes Leiterbahnenmuster auf weisen.

8. Stellelement nach Anspruch 1 bis 7, ***dadurch gekennzeichnet,* daß** das Stellelement als Drehsteller ausgeführt ist und einen kreisförmigen Kontaktträger (13) aufweist.

9. Stellelement nach Anspruch 1 bis 7, ***dadurch gekennzeichnet*, daß** das Stellelement als Schiebesteller mit einem langgestreckten Kontaktträger (13) ausgeführt ist.

10. Stellelement nach Anspruch 8, ***dadurch gekennzeichnet*, daß** die im Gehäuse (73) drehbar gelagerte Achse (72) des Drehstellers (11) mit einer als Programmwähler ausgebildeten Scheibe verbunden ist, die mit Kerben (92) auf dem Scheibenrand versehen und am Gehäuse (71) eine flexible Nase (81) vorgesehen ist, wobei die Nase (81) in eine der Kerben (71) in einer bestimmten Raststellung eingreifend angeordnet ist.

11. Stellelement nach Anspruch 10, ***dadurch gekennzeichnet,* daß** der Programmwähler sich mit je nach Winkel unterschiedlicher Länge mit der Achse des Drehstellers bewegt und von einer am Gehäuse des Drehstellers (Programmfeder) so abgetastet wird, daß eine Raststellung entsteht, wenn die Programmfeder (17) eine Kerbe in dem Programmwähler passiert.

12. Stellelement nach Anspruch 8 und 10 bis 11, ***dadurch gekennzeichnet*, daß** der Programmwähler in einen Hohlraum an der Rückseite des Stellelements auf die Drehachse aufgesteckt ist und austauschbar ausgebildet ist.

13. Stellelement nach Anspruch 8 und 10 bis 12, ***dadurch gekennzeichnet*, daß** in dem Drehsteller die Funktionen eines Wahlschalters und eines Drehreglers kombiniert sind.

14. Stellelement nach Anspruch 1 bis 7, ***dadurch gekennzeichnet*, daß** das Stellelement sowohl als Drehsteller als auch als Schiebesteller ausführbar ist.

15. Stellelement nach Anspruch 1 bis 14, ***dadurch gekennzeichnet,* daß** der drehbar oder schiebbar ausgeführte Griff (11) des Stellelementes bei einer Bedienung einen Bereich der Leiterbahnen betätigt, der in konfigurierbare Abschnitte unterteilt ist, die den durch einen Programmwähler bestimmten Schaltstufen und/oder Regelbereichen entsprechen.

16. Verfahren zur Informationsverarbeitung von Impulsen, die durch eine mechanisch mittels eines Stellelementes bedienbare Kontaktfeder durch Kontaktschließung von Kontakten einer aus zwei mit einem Leiterbahnenmuster versehenen Kanälen bestehenden Kontaktfläche eines Stellelementes zur Bedienung elektronischer Geräte nach Anspruch 1 bis 15 geliefert werden, ***dadurch gekennzeichnet*, daß** die Impulse auf zwei Kanälen erzeugt werden, diese Impulse im zeitlichen Verhältnis der Impulse zweier aufeinander folgender, die Position des Griffes (11) mit Kontaktfeder (12) kennzeichnenden Impulse von einer Dekodiereinheit (14) verarbeitet werden und die ermittelte Position an einen elektronischen Speicher zur Weiterverarbeitung übertragen wird.

17. Verfahren nach Anspruch 16, ***dadurch gekennzeichnet,* daß** die Auswertung der Impulsfolgen in der Dekodiereinheit (14) vorgenommen wird, indem jede Änderung des Logik-Pegels der Impulse beider Kanäle (1; 2) registriert wird, dann der Zeitpunkt der letzten Pegeländerung exakt gespeichert wird, wobei als Zeitpunkt die in der Dekodiereinheit (14) üblicherweise vorhandene die Uhrzeit, ausgehend von einem willkürlichen Startpunkt beispielsweise in Millisekunden messende Timer-Funktion ausgenutzt wird.

18. Verfahren nach Anspruch 16 und 17, ***dadurch gekennzeichnet,* daß** die Timer-Funktion in Verbindung mit einer Differenzbildung zweier registrierter Zeitpunkte als Stoppuhr eingesetzt wird.

19. Verfahren nach Anspruch 17 bis 18, ***dadurch gekennzeichnet*, daß** die Logik-Pegelerfassung der Impulse in sechs aufeinander folgenden Schritten erfolgt, indem im Kanal (1) hightime, lowtime und pend.-hightime und im Kanal (2) hightime, lowtime und pend.-hightime als Informationen registriert werden, indem durch die Timer-Funktion bei einer steigenden Flanke des Pegels der Zeitpunkt des Pegelwechsels von Low auf High als Ereignis hightime im Register des betreffenden Kanals als pend.-hightime gespeichert wird und bei einer fallenden Flanke des Pegels der Zeitpunkt des Pegelwechsels als lowtime im Register des betroffenen Kanals als lowtime erfaßt wird und anschließend die Differenz zwischen den Zeitpunkten der Ereignisse von lowtime und hightime gebildet wird und hieraus die Impulslänge des letzten vollständigen Impulses in jedem Kanal (1; 2) errechnet und anschließend aus dem Vergleich der Impulslängen des jeweiligen Kanals die Position des Stellelementes bestimmt wird.

## Claims

1. An actuating element for the operation of electronic devices, **characterised in that** a knob (11) of the actuating element is mounted in a mechanically movable manner in a housing (71) and is connected to a contact spring (12) slidably arranged on a provided contact carrier (13) configured as a disc or track, the contact carrier (13) comprising two conductors provided in each case with a coded conductor pattern, the pattern sequence thereof being specific for each position of the knob (11) of the actuating element and a decoding unit (14) being provided, processing pulses emitted by the movement of the knob (11) and the closure of the contacts of the contact spring (12) on two coded conductor patterns, which calculates the position of the knob of the actuating element from the time ratio between the pulses from the two conductor patterns and an electronic memory (15) being provided, arranged downstream, the contents thereof expressing at any time the position of the knob of the actuating element.

2. The ctuating element according to Claim 1, **characterised in that** the contact carrier (13) acted upon by the contact spring (12) comprises two separate conductors (21; 22) which in each case form a channel (1; 2) and which are connected to the electronic decoding unit (14) via an interface.

3. The actuating element according to Claim 1 and 2, **characterised in that** the conductors (21; 22) are arranged parallel to one another in one plane.

4. The actuating element according to Claim 1 to 3, **characterised in that** the conductors (21; 22) are of comb-shaped configuration, and the comb teeth of the one conductor are arranged in gaps between two comb teeth of the other conductor.

5. The actuating element according to Claim 1 to 4, **characterised in that** the comb teeth of the conductors (21; 22) have a different width and the widths from one end to the other end of a conductor are configured to increase.

6. The actuating element according to Claim 1 to 5, **characterised in that** the conductors which are located in parallel and are of comb-shaped configuration are arranged with an opposing width sequence relative to one another, in each case a narrow comb tooth of the one conductor being arranged to engage in a gap between two wider comb teeth of the other conductor.

7. The actuating element according to Claim 1 to 6, **characterised in that** the conductors located parallel to one another and provided with comb teeth have a coded conductor pattern relative to one another.

8. The actuating element according to Claim 1 to 7, **characterised in that** the actuating element is designed as a rotary actuator and has a circular contact carrier (13).

9. The actuating element according to Claim 1 to 7, **characterised in that** the actuating element is designed as a slide actuator with an elongate contact carrier (13).

10. The actuating element according to Claim 1 to 9, **characterised in that** the shaft (72) of the rotary actuator (11) rotatably mounted in the housing (73) is connected to a disc configured as a program selector, which is provided with notches (92) on the disc edge and a flexible lug (81) is provided on the housing (71), the lug (81) being arranged to engage in one of the notches (71) in a specific locked position.

11. The actuating element according to Claim 1 to 10, **characterised in that** the program selector moves with the shaft of the rotary actuator, to a different length in each case according to the angle, and is scanned by a (program spring) on the housing of the rotary actuator, so that a locked position is produced when the program spring (17) passes a notch in the program selector.

12. The actuating element according to Claim 1 to 11, **characterised in that** the program selector is inserted into a cavity on the rear face of the actuating element onto the rotational axis and is configured to be replaceable.

13. The actuating element according to Claim 1 to 12, **characterised in that** the functions of a selector switch and rotary dial are combined in the rotary actuator.

14. The actuating element according to Claim 1 to 13, **characterised in that** the actuating element may be designed both as a rotary actuator and as a slide actuator.

15. The actuating element according to Claim 1 to 14, **characterised in that** the knob (11) of the actuating element which is designed to be rotatable or slidable, during operation actuates a region of the conductors which is divided into configurable portions which, on the one hand, correspond to the switching stages and/or adjustment ranges determined by the program selector and which, on the other hand, are defined by the method.

16. A method for processing information of pulses, which are delivered by a contact spring which may be operated mechanically by means of an actuating element, by the closure of contacts of a contact surface of an actuating element consisting of two channels provided with a conductor pattern, for the operation of electronic devices according to Claim 1 to 15, **characterised in that** the pulses are produced on two channels, said pulses being processed by a decoding unit (14) in a time ratio of the pulses of two successive pulses, identifying the position of the knob (11) with contact springs (12), and the determined position is transmitted to an electronic memory for further processing.

17. The method according to Claim 14, **characterised in that** the evaluation of the pulse sequences is undertaken in the decoding unit (14) by each alteration of the logic level of the pulses of both channels (1; 2) being registered, then the point in time of the last level alteration being accurately stored, the timer function generally present in the decoding unit (14) which measures, for example in milliseconds, the time of day based on an arbitrary starting point, being used as the point in time.

18. The method according to Claim 14 and 15, **characterised in that** the timer function is used in combination with a differentiation of two registered times as a stopwatch.

19. The method according to Claim 14 to 16, **characterised in that** the logic level detection of the pulses takes place in six consecutive steps, **in that** in channel (1) hightime, lowtime and pend.-hightime are registered as information and in channel (2) hightime, lowtime and pend.-hightime are registered as information, **in that**, with a rising flank of the level, the point in time of the level change from low to high is stored as a hightime event in the register of the relevant channel by the timer function as pend.-hightime and, with a falling flank of the level, the point in time of the level change is detected as lowtime in the register of the relevant channel and subsequently the difference is formed between the points in time of the lowtime and hightime events and the pulse length of the last complete pulse in each channel (1; 2) is calculated therefrom and subsequently the position of the actuating element is determined from the comparison of the pulse lengths of the respective channel.

## Revendications

1. Elément de réglage pour la commande d'appareils électroniques, **caractérisé en ce qu'**une poignée (11) de l'élément de réglage est montée dans un boîtier (71) de façon mécaniquement mobile et est reliée à un ressort de contact (12) disposé de façon coulissante sur un support de contact (13) prévu et conçu comme disque ou bande, le support de contact (13) présentant deux pistes conductrices dotées chacune d'un modèle de piste conductrice codé, pistes dont la succession de modèles est spécifique pour chaque position de la poignée (11) de l'élément de réglage, et une unité de décodage (14) traitant des impulsions émises sur deux modèles de piste conductrice codés par déplacement de la poignée (11) et fermeture de contact du ressort de contact (12), laquelle unité calcule la position de la poignée de l'élément de réglage à partir du rapport dans le temps entre les impulsions et les deux modèles de piste conductrice, et une mémoire (15) électronique subordonnée, dont le contenu exprime à tout moment la position de la poignée de l'élément de réglage, étant prévues.

2. Elément de réglage selon la revendication 1, **caractérisé en ce que** le support de contact (13) sollicité par le ressort de contact (12) présente deux pistes conductrices (21 ; 22) séparées, lesquelles forment chacune un canal (1 ; 2) et sont reliées à l'unité de décodage (14) électronique par une interface.

3. Elément de réglage selon les revendications 1 et 2, **caractérisé en ce que** les pistes conductrices (21 ; 22) sont disposées dans un plan parallèlement entre elles.

4. Elément de réglage selon les revendications 1 à 3, **caractérisé en ce que** les pistes conductrices (21 ; 22) sont conçues en forme de peigne et des dents de peigne de l'une des pistes conductrices sont disposées dans des interstices entre deux dents de peigne de l'autre piste conductrice.

5. Elément de réglage selon les revendications 1 à 4, **caractérisé en ce que** les dents de peigne des pistes conductrices (21 ; 22) présentent une largeur différente et les largeurs sont conçues en progressant d'une extrémité à l'autre extrémité d'une piste conductrice.

6. Elément de réglage selon les revendications 1 à 5, **caractérisé en ce que** les pistes conductrices, disposées en parallèle et conçues en forme de peigne, sont disposées avec une succession de largeurs opposée les unes par rapport aux autres, à chaque fois une dent de peigne étroite d'une des pistes conductrices étant disposée en s'engageant dans un interstice entre deux dents de peigne plus larges de l'autre piste conductrice.

7. Elément de réglage selon les revendications 1 à 6, **caractérisé en ce que** les pistes conductrices dotées de dents de peigne et disposées en parallèle présentent un modèle de piste conductrice codé et dans l'attribution entre elles.

8. Elément de réglage selon les revendications 1 à 7, **caractérisé en ce que** l'élément de réglage est réalisé sous forme d'actionneur rotatif et présente un support de contact (13) circulaire.

9. Elément de réglage selon les revendications 1 à 7, **caractérisé en ce que** l'élément de réglage est réalisé sous forme d'actionneur coulissant avec un support de contact (13) étiré en longueur.

10. Elément de réglage selon les revendications 1 à 9, **caractérisé en ce que** l'axe (72), logé de façon rotative dans le boîtier (73), de l'actionneur rotatif (11) est relié à un disque conçu comme sélecteur de programme, qui est doté d'entailles (92) sur le bord du disque, et un ergot (81) flexible est prévu sur le boîtier (71), l'ergot (81) étant disposé en s'engageant dans l'une des entailles (71) dans une position d'encliquetage définie.

11. Elément de réglage selon les revendications 1 à 10, **caractérisé en ce que** le sélecteur de programme se déplace avec l'axe de l'actionneur rotatif en fonction de l'angle de longueur différente et est balayé par un élément logé sur le boîtier de l'actionneur rotatif (ressort de programme) de telle sorte qu'une position d'encliquetage se forme lorsque le ressort de programme (17) passe par une entaille dans le sélecteur de programme.

12. Elément de réglage selon les revendications 1 à 11, **caractérisé en ce que** le sélecteur de programme est emboîté dans une cavité sur l'arrière de l'élément de réglage sur l'axe de rotation et est conçu de façon amovible.

13. Elément de réglage selon les revendications 1 à 12, **caractérisé en ce que** les fonctions d'un sélecteur et d'un régulateur rotatif sont combinées dans l'actionneur rotatif.

14. Elément de réglage selon les revendications 1 à 13, **caractérisé en ce que** l'élément de réglage peut être réalisé aussi bien sous forme d'actionneur rotatif que sous forme d'actionneur coulissant.

15. Elément de réglage selon les revendications 1 à 14, **caractérisé en ce que** la poignée (11), conçue de façon rotative ou coulissante, de l'élément de réglage actionne lors d'une commande une zone des pistes conductrices qui est subdivisée en parties configurables, lesquelles d'une part correspondent aux niveaux de commutation et/ou plages de réglage définis par le sélecteur de programme et d'autre part sont définies par le procédé.

16. Procédé pour le traitement d'information d'impulsion qui sont fournies par un ressort de contact pouvant être commandé mécaniquement au moyen d'un élément de réglage par la fermeture de contacts d'une surface de contact, constituée de deux canaux dotés d'un modèle de piste conductrice, d'un élément de réglage pour la commande d'appareils électroniques selon les revendications 1 à 15, **caractérisé en ce que** les impulsions sont générées sur deux canaux, ces impulsions étant traitées par une unité de décodage (14) dans le rapport dans le temps des impulsions de deux impulsions consécutives et caractérisant la position de la poignée (11) avec ressort de contact (12), et la position déterminée est transmise à une mémoire électronique pour le traitement ultérieur.

17. Procédé selon la revendication 14, **caractérisé en ce que** l'analyse des séquences d'impulsions est effectuée dans l'unité de décodage (14) par le fait que chaque variation du niveau de logique des impulsions des deux canaux (1, 2) est enregistrée, le temps de la dernière variation de niveau est mémorisé alors de façon précise, la fonction de minuterie mesurant par exemple en millisecondes l'heure présente habituellement dans l'unité de décodage (14), à partir d'un point de démarrage arbitraire, étant utilisée comme moment.

18. Procédé selon les revendications 14 et 15, **caractérisé en ce que** la fonction de minuterie est utilisée comme chronomètre en liaison avec une formation de différence de deux moments enregistrés.

19. Procédé selon les revendications 14 à 16, **caractérisé en ce que** l'enregistrement de niveau de logique des impulsions s'effectue en six étapes consécutives du fait qu'on enregistre sous forme d'informations dans le canal (1) hightime, lowtime et pend.-hightime et dans le canal (2) hightime, lowtime et pend.-hightime, du fait que, par la fonction de minuterie et avec un flanc croissant du niveau, le moment du changement de niveau de Low à High comme événement hightime est mémorisé dans le registre du canal correspondant comme pend.-hightime et que, dans le cas d'un flanc croissant du niveau, le moment du changement de niveau comme évènement lowtime est enregistré dans le registre du canal concerné comme lowtime et qu'ensuite la différence entre les moments des événements de lowtime et hightime est formée et que, à partir de là, la longueur d'impulsion de la dernière impulsion complète est calculée dans chaque canal (1 ; 2) et qu'ensuite la position de l'élément de réglage est déterminée à partir de la comparaison des longueurs d'impulsion du canal respectif.
